# EUROPEAN PATENT SPECIFICATION

(11) **EP 2 254 237 B1**
(45) Date of publication and mention of the grant of the patent: **25.07.2012**
(21) Application number: 10163656.1
(22) Date of filing: 21.05.2010
(51) Int. Cl.: H04B 1/04, H03F 1/02, H04W 52/04, H04W 52/02, H04L 5/00, H04W 72/04

(54) **Method and device for adjusting power amplifier voltage and controlling time slots**
Verfahren und Vorrichtung zur Einstellung der Stromverstärkungsspannung und Steuerung von Time Slots
Procédé et dispositif d'ajustement de la tension d'un amplificateur électrique et contrôle des intervalles de temps

(30) Priority: 21.05.2009 CN 200910107491
(43) Date of publication of application: 24.11.2010
(60) Divisional application: 12172419.9
(73) Proprietor: Huawei Technologies Co., Ltd., Shenzhen, Guangdong 518129 (CN)
(72) Inventor: Guoqiang, Yao, 518129, Shenzhen Guangdong (CN)
(74) Representative: Epping - Hermann - Fischer

(56) References cited:
- EP-A1- 1 401 098
- WO-A2-2008/054310
- US-A1- 2009 088 100
- US-B1- 6 223 056
- US-B1- 6 577 608

## Description

### FIELD OF THE TECHNOLOGY

The present invention relates to the field of communications, and more particularly to a method and a device for adjusting a power amplifier voltage.

### BACKGROUND OF THE INVENTION

A multi-carrier base station has advantages of high integration level and high energy efficiency ratio. The application of multi-carrier technology in Global System for Mobile Communications (GSM) network construction is capable of reducing capital expenditure (CAPEX) of network construction for the operator, and meanwhile realizing low operating expenditure (OPEX) of network maintenance.

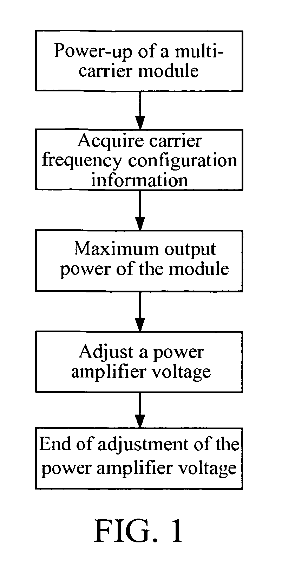

As shown in FIG. 1, an existing multi-carrier energy saving technical solution is to calculate a possible maximum output power by a multi-carrier module after running on power-up, adjust a drain voltage of power amplifier to a preset voltage value, and perform one-time static voltage adjustment of the power amplifier according to static configuration parameters for a multi-carrier base station by a base station controller. However, for a GSM base station, the channel modulation mode, channel power, and channel occupation of each carrier are continuously changing, so that if a power amplifier voltage is not dynamically adjusted after the base station is powered up, a power amplifier efficiency of a power amplifier at low power output greatly drops as compared with the efficiency at high power output when the downlink power control of the base station takes effect, thereby reducing the energy efficiency of a GSM network.

Meanwhile, when the existing energy saving technical solution is applied in the multi-carrier module, dynamic turn-off of a power amplifier voltage of idle time slots of the multi-carrier module deteriorates a radio frequency (RF) transmit index of the multi-carrier module, and thus static power consumption of the power amplifier cannot be reduced.

WO 2008/054310 A2 relates to a method for sending reserved sub-carriers to a UE for the purpose of reducing peak to average power ratio of the transmitted signal to ensure sufficient quality of the modulated signal to achieve high data rate, including the steps of sending the information related to dynamic activation and deactivation of reserved sub-carriers on a common channel, which is readable for all UEs in idle and in connected mode; dynamically activating the transmission of the reserved sub- carriers in a cell when high modulation quality is to be maintained; dynamically deactivating the transmission of the reserved sub-carriers in a cell when high modulation quality is not required. The invention furthermore relates to a radio base station and a UE relating to said method. Further prior art documents US6223056, US2009/088100, US6577608, and EP1401098, are directed to power sypply control in RF amplifiers.

### SUMMARY OF THE INVENTION

Accordingly, the present invention is directed to a method and a device for adjusting a power amplifier voltage. The present invention provides the following technical solutions in embodiments.

A method for adjusting a power amplifier voltage is provided, which includes the following steps.

A base station determines a power amplifier voltage in a statistical time period according to carrier power control information and a relation between a power amplifier output power and a power amplifier efficiency. A power amplifier voltage in the previous statistical time period of the statistical time period of a current time point is selected as a target power amplifier voltage. A power amplifier voltage at the current time point is adjusted according to the target power amplifier voltage. A power amplifier of a multi-carrier module works in a linear amplification area in the statistical time period.

A base station is provided, which includes a statistical time period determination unit, a power amplifier voltage determination unit, a target power amplifier voltage selection unit, and a power amplifier voltage adjustment unit.

The statistical time period determination unit is configured to determine a statistical time period of a power amplifier voltage. The power amplifier voltage determination unit is configured to determine a power amplifier voltage in the statistical time period determined by the statistical time period determination unit according to carrier power control information and a relation between a power amplifier output power and a power amplifier efficiency. The target power amplifier voltage selection unit is configured to select a power amplifier voltage determined by the power amplifier voltage determination unit in the previous statistical time period of the statistical time period of a current time point as a target power amplifier voltage. The power amplifier voltage adjustment unit is configured to adjust a power amplifier voltage at the current time point according to the target power amplifier voltage determined by the target power amplifier voltage selection unit.

Through the method in the embodiment of the present invention, when the power amplifier of the multi-carrier module of the base station works in a linear amplification area, the base station adjusts a power amplifier voltage at a current time point by comparing power amplifier voltages in a first statistical time period and a second statistical time period with the power amplifier voltage at the current time point according to a relation between a power amplifier output power and a power amplifier efficiency, so that the base station may dynamically adjust the power amplifier voltage after power-up.

### BRIEF DESCRIPTION OF THE DRAWINGS

To illustrate the technical solution according to the embodiments of the present invention or in the prior art more clearly, the accompanying drawings for describing the embodiments or the prior art are given briefly below. Apparently, the accompanying drawings in the following description are only some embodiments of the present invention, and persons of ordinary skill in the art can derive other drawings from the accompanying drawings without creative efforts.
FIG. 1 is a flow chart illustrating setting of a power amplifier voltage in an existing multi-carrier energy saving technical solution;
FIG. 2 is a flow chart of a method for adjusting a power amplifier voltage in an embodiment of the present invention;
FIG. 3 is a schematic structural view of a base station in an embodiment of the present invention;
FIG. 4 is a schematic structural view of a power amplifier voltage determination unit in an embodiment of the present invention;
FIG 5 is a schematic structural view of a communication system in an embodiment of the present invention;
FIG. 6 is a schematic view illustrating a relation between a carrier frequency time slot and a carrier time slot in an embodiment of the present invention;
FIG. 7 is a flow chart of another method for controlling time slot occupancy in an embodiment of the present invention;
FIG. 8 is a schematic structural view of another base station in an embodiment of the present invention;
FIG. 9 is a schematic structural view of a base station controller in an embodiment of the present invention; and
FIG. 10 is a schematic structural view of another communication system in an embodiment of the present invention.

### DETAILED DESCRIPTION OF THE EMBODIMENTS

The technical solution under the present invention is elaborated below by reference to accompanying drawings. Evidently, the embodiments described below are for the exemplary purpose only, without covering all embodiments of the present invention. Person having ordinary skill in the art can derive other embodiments from the embodiments given herein without making any creative effort, and all such embodiments are covered in the protection scope of the present invention.

The multi-carrier energy saving technical solution in the prior art merely statically determines carrier frequency configuration information of a base station. However, since the channel modulation mode, channel power, and channel occupation of each carrier are continuously changing, if a power amplifier voltage is not dynamically adjusted after power-up of the base station, a power amplifier efficiency of a power amplifier at low power output greatly drops as compared with the efficiency at full power output when the downlink power control of the base station takes effect, thereby reducing the energy efficiency of a GSM network.

A method for adjusting a power amplifier voltage is provided in an embodiment of the present invention, which includes: determining, by a base station, a power amplifier voltage in a statistical time period according to carrier power control information and a relation between a power amplifier output power and a power amplifier efficiency; selecting a power amplifier voltage in the previous statistical time period of the statistical time period of a current time point as a target power amplifier voltage; and adjusting a power amplifier voltage at the current time point according to the target power amplifier voltage. A power amplifier of a multi-carrier module works in a linear amplification area in the statistical time period.

Through the method in the embodiment of the present invention, when the power amplifier of the multi-carrier module of the base station works in a linear amplification area, the base station adjusts a power amplifier voltage at a current time point by comparing a power amplifier voltage in a statistical time period with the power amplifier voltage at the current time point according to a relation between a power amplifier output power and a power amplifier efficiency, so that the base station may dynamically adjust the power amplifier voltage after power-up. Further, it can be known from the relation between the power amplifier output power and the power amplifier efficiency that, when the power amplifier of the multi-carrier module of the base station works in the linear amplification area, the amplitude of a power amplifier gain is substantially unchanged by moderately reducing the power amplifier voltage at the current time point when the power amplifier output power is decreased, so that the power amplifier efficiency can be improved by reducing the power amplifier voltage.

For ease of description, a GSM multi-carrier base station is taken as a specific example for description in embodiments of the present invention.

Further illustrations are given below with reference to specific implementations and the accompanying drawings.

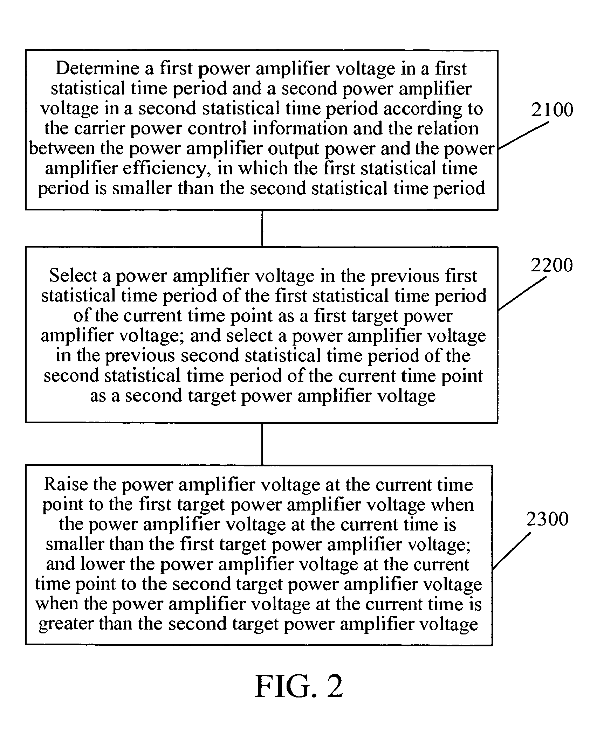

As shown in FIG. 2, a method for adjusting a power amplifier voltage in an embodiment of the present invention includes the following steps.

In 2100, a first power amplifier voltage in a first statistical time period and a second power amplifier voltage in a second statistical time period are determined according to the carrier power control information and the relation between the power amplifier output power and the power amplifier efficiency. The first statistical time period is smaller than the second statistical time period.

After a base station runs on power-up, when a power amplifier of a multi-carrier module of the base station works in a linear amplification area, the multi-carrier module of the base station calculates an output power of each working time slot in each statistical time period of the multi-carrier module according to carrier power control information from a certain time point, and determines an average output power of the power amplifier in each statistical time period according to the output power of each working time slot in the statistical time period. Then, the multi-carrier module determines a power amplifier voltage corresponding to the average output power in each statistical time period according to a power amplifier output power-power amplifier efficiency curve in combination with the average output power of the power amplifier of the multi-carrier module. The carrier power control information may include a carrier static power level, a dynamic power level, a carrier power amplifier switch, carrier power configuration information, a channel modulation type, and a carrier quantity. The statistical time periods may be two preset independent statistical time periods, that is, a first statistical time period and a second statistical time period. The second statistical time period is greater than the first statistical time period. For example, the first statistical time period may be about 3 seconds, while the second statistical time period may be about 3 minutes. The multi-carrier module of the base station determines an output power of each working time slot in each first statistical time period and an output power of each working time slot in each second statistical time period, and determines a first power amplifier voltage corresponding to an average power in each first statistical time period and a second power amplifier voltage corresponding to an average power in each second statistical time period according to the output power of each working time slot in each first statistical time period and each second statistical time period. The first statistical time period is smaller than the second statistical time period, thereby enabling rapid raise and slow lowering in the adjustment of the power amplifier working voltage, which has a small influence on the network quality.

In 2200, a power amplifier voltage in the previous first statistical time period of the first statistical time period of the current time point is selected as a first target power amplifier voltage; and a power amplifier voltage in the previous second statistical time period of the second statistical time period of the current time point is selected as a second target power amplifier voltage.

When the multi-carrier module of the base station works in a power amplifier linear work area, the amplitude of a power amplifier gain is substantially unchanged by reducing a power amplifier voltage when a power amplifier output power is decreased, so that the power amplifier efficiency is improved by reducing the power amplifier voltage. Therefore, in the embodiment of the present invention, a power amplifier voltage at a current time point is adjusted by using a power amplifier voltage in a previous statistical time period of a statistical time period of the power amplifier voltage at the current time point. Since the statistical time periods may be the first statistical time period and the second statistical time period, correspondingly, a power amplifier voltage in the previous first statistical time period of the first statistical time period of the current time point may be referred to as a first target power amplifier voltage, and a power amplifier voltage in the previous second statistical time period of the second statistical time period of the current time point may be referred to as a second target power amplifier voltage.

In 2300, the power amplifier voltage at the current time point is raised to the first target power amplifier voltage when the power amplifier voltage at the current time is smaller than the first target power amplifier voltage; and the power amplifier voltage at the current time point is lowered to the second target power amplifier voltage when the power amplifier voltage at the current time is greater than the second target power amplifier voltage.

When the first target power amplifier voltage is greater than the power amplifier voltage at the current time point, the multi-carrier module raises the power amplifier voltage at the current time point to the first target power amplifier voltage, and meanwhile updates a downlink predistortion parameter of a transmit channel; when the second target power amplifier voltage is smaller than the power amplifier voltage at the current time point, the multi-carrier module lowers the power amplifier voltage at the current time point to the second target power amplifier voltage, and meanwhile updates the downlink predistortion parameter of the transmit channel; and when the target power amplifier voltage is equal to the power amplifier voltage at the current time point, the multi-carrier module does not adjust the power amplifier voltage at the current time point, and meanwhile maintains the original downlink predistortion parameter of the transmit channel. Since the statistical time periods may be the first statistical time period and the second statistical time period, if the power amplifier voltage at the current time is smaller than the first target power amplifier voltage, the power amplifier voltage at the current time point is raised to the first target power amplifier voltage; if the power amplifier voltage at the current time is greater than the first target power amplifier voltage, the power amplifier voltage at the current time point may not be lowered to the first target power amplifier voltage since the first statistical time period is short; and if the power amplifier voltage at the current time is greater than the second target power amplifier voltage, the power amplifier voltage at the current time point may be lowered to the second target power amplifier voltage.

Through the method in the embodiment of the present invention, when the power amplifier of the multi-carrier module of the base station works in a linear amplification area, the base station adjusts a power amplifier voltage at a current time point by comparing power amplifier voltages in a first statistical time period and a second statistical time period with the power amplifier voltage at the current time point according to a relation between a power amplifier output power and a power amplifier efficiency, so that the base station may dynamically adjust the power amplifier voltage after power-up. Further, it can be known from the relation between the power amplifier output power and the power amplifier efficiency that, when the power amplifier of the multi-carrier module of the base station works in the linear amplification area, the amplitude of a power amplifier gain is substantially unchanged by reducing the power amplifier voltage at the current time point if an average power in a previous second statistical time period of the second statistical time period of the current time point is decreased, that is, the second target power amplifier voltage is smaller than the power amplifier voltage at the current time point, so that the power amplifier efficiency can be improved by reducing the power amplifier voltage at the current time point.

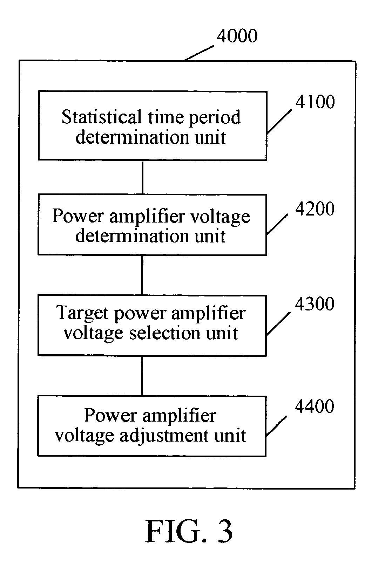

As shown in FIG. 3, a base station 4000 in an embodiment of the present invention includes: a statistical time period determination unit 4100, a power amplifier voltage determination unit 4200, a target power amplifier voltage selection unit 4300, and a power amplifier voltage adjustment unit 4400.

The statistical time period determination unit 4100 is configured to determine a statistical time period of a power amplifier voltage. The power amplifier voltage determination unit 4200 is configured to determine a power amplifier voltage in the statistical time period determined by the statistical time period determination unit 4100 according to carrier power control information and a relation between a power amplifier output power and a power amplifier efficiency. The target power amplifier voltage selection unit 4300 is configured to select a power amplifier voltage determined by the power amplifier voltage determination unit 4200 in the previous statistical time period of the statistical time period of the current time point as a target power amplifier voltage. The power amplifier voltage adjustment unit 4400 is configured to adjust a power amplifier voltage at the current time point according to the target power amplifier voltage determined by the target power amplifier voltage selection unit 4300 and the power amplifier voltage at the current time point.

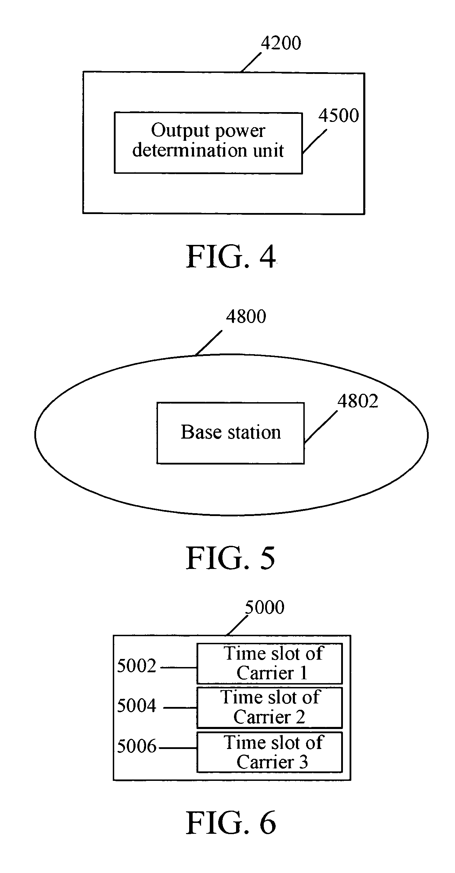

Further, as shown in FIG. 4, the power amplifier voltage determination unit 4200 includes an output power determination unit 4500.

The output power determination unit 4500 is configured to determine an average power in the statistical time period according to the carrier power control information.

Further, the statistical time period determination unit 4100 is further configured to determine a first statistical time period and a second statistical time period. The first statistical time period is smaller than the second statistical time period. The power amplifier voltage determination unit 4200 is further configured to determine a first power amplifier voltage in the first statistical time period and a second power amplifier voltage in the second statistical time period that are determined by the statistical time period determination unit 4100 according to the carrier power control information and the relation between the power amplifier output power and the power amplifier efficiency. The target power amplifier voltage selection unit 4300 is further configured to select the first power amplifier voltage determined by the power amplifier voltage determination unit 4200 in the previous first statistical time period of the first statistical time period of the current time point as a first target power amplifier voltage, and select the second power amplifier voltage determined by the power amplifier voltage determination unit 4200 in the previous second statistical time period of the second statistical time period of the current time point as a second target power amplifier voltage. The power amplifier voltage adjustment unit 4400 is further configured to raise the power amplifier voltage at the current time point to the first target power amplifier voltage if the power amplifier voltage at the current time point is smaller than the first target power amplifier voltage; and lower the power amplifier voltage at the current time point to the second target power amplifier voltage if the power amplifier voltage at the current time point is greater than the second target power amplifier voltage.

As shown in FIG. 5, a communication system 4800 is further provided in an embodiment of the present invention. The communication system 4800 includes a base station 4802. The base station 4802 may accomplish all functions of the base station in the embodiment of the above method for adjusting a power amplifier voltage in the present invention.

Due to large demands on matching capacitance of a power amplifier gate of a multi-carrier module, during dynamic turn-on and turn-off of carrier frequency time slots, a power amplifier gate voltage cannot vary rapidly from high to low with a control signal in time during the turn-on and turn-off of the carrier frequency time slots, so that a carrier RF transmit index of the multi-carrier module is deteriorated. In order to dynamically adjust time slot occupancy in case of traffic occupancy on the multi-carrier module, a method for controlling time slots is provided in an embodiment of the present invention, which includes: determining, by a base station, a time length required for carrier frequency time slots of a multi-carrier module thereof from a dormant state to an available state; and controlling, by the base station, the carrier frequency time slots and carrier time slots of the multi-carrier module according to the time length and time slot occupancy information of the multi-carrier module. In the embodiment of the present invention, the carrier frequency time slots are time slot columns having the same time slot number on all carriers in the multi-carrier module, and the carrier time slots are time slots corresponding to different carriers in the carrier frequency time slots. For ease of understanding, FIG. 6 describes a relation between a carrier frequency time slot and a carrier time slot as an example. Assume that a carrier frequency time slot 5000 is a time slot column having the same time slot number on all carriers in the multi-carrier module of the base station, and the multi-carrier module has 3 carriers thereon. Therefore, 3 time slots may be multiplexed on the carrier frequency time slot 5000, each time slot on the carrier frequency time slot may be referred to as a carrier time slot, and correspondingly, the time slot of the carrier 1 on the carrier frequency time slot 5000 is a carrier time slot 5002, the time slot of the carrier 2 on the carrier frequency time slot 5000 is a carrier time slot 5004, and the time slot of the carrier 3 on the carrier frequency time slot 5000 is a carrier time slot 5006. Thus, in case of multiple carriers, assignment of traffic to a carrier frequency time slot may be considered as assignment of traffic to carrier time slots of carriers on the multi-carrier module corresponding to the carrier frequency time slot. The dormant state of the carrier frequency time slot is a time slot state when a carrier frequency turn-off circuit of the carrier frequency time slot in the multi-carrier module is turned off, and correspondingly, all carrier time slots on the carrier frequency time slot are in the dormant state. The available state of the carrier frequency time slot is a time slot state when a carrier frequency output RF index of the carrier frequency time slot is normal, that is, a time slot state when the carrier frequency output RF index of the carrier frequency time slot is normal under correction of a carrier frequency transmit channel of the carrier frequency time slot by a digital predistortion algorithm after power supply of the carrier frequency turn-off circuit of the carrier frequency time slot is recovered. Through the method in this embodiment, the base station determines such a time length from activation of carrier frequency time slots in a dormant state to a state in which a power amplifier output RF index is normal after the carrier frequency time slots are assigned with traffic. The time length is a time length required for recovery of a dormant circuit of the multi-carrier module to a working state. The base station may control carrier frequency time slots and carrier time slots of the multi-carrier module to perform traffic assignment according to the time length and the time slot occupancy information of the multi-carrier module or turn off a part of idle carrier frequency time slots in an active state when the idle carrier frequency time slots in the active state exist, so as to solve the problem of deterioration of an RF transmit index of the multi-carrier module caused by the dynamic turn-off of the idle carrier frequency time slots in the active state of the multi-carrier module by the base station. Further, a part of carrier frequency time slots of the multi-carrier module enter the dormant state by turning off the turn-off idle carrier frequency time slots in the active state, so that the quantity of time slots in the active state of the multi-carrier module is reduced, thereby lowering power consumption of the multi-carrier module, and realizing energy saving of the multi-carrier module.

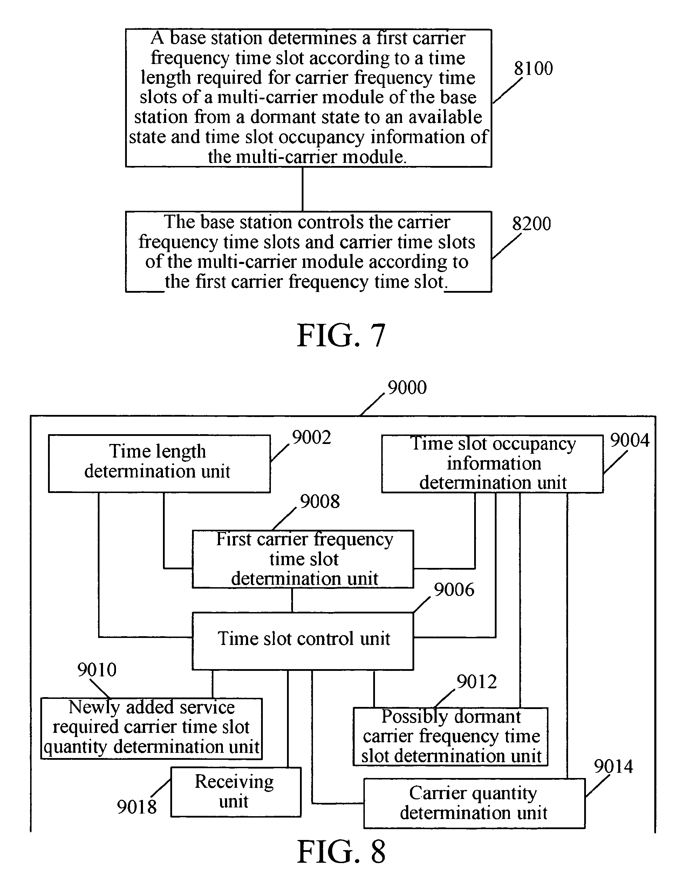

Another method for controlling time slots is provided in an embodiment of the present invention. The method is specifically described through an example in which a time length required for carrier frequency time slots of a multi-carrier module of a base station from a dormant state to an available state is a time length of one carrier frequency time slot. As shown in FIG. 7, the method includes the following steps.

In 8100, a base station determines a first carrier frequency time slot according to a time length required for carrier frequency time slots of a multi-carrier module of the base station from a dormant state to an available state and time slot occupancy information of the multi-carrier module.

The base station may determine carrier frequency time slots having traffic occupancy according to the time slot occupancy information of the multi-carrier module. When a time slot quantity of the carrier frequency time slots having traffic occupancy is zero, the first carrier frequency time slot is one first activated carrier frequency time slot after the multi-carrier module is activated in case that the time length required for carrier frequency time slots from a dormant state to an available state is the time length of one carrier frequency time slot. For another example, if the time length required for carrier frequency time slots from a dormant state to an available state is the time length of 2 or 1.5 carrier frequency time slots, the first carrier frequency time slot are two first activated carrier frequency time slots after the multi-carrier module is activated. That is to say, the first carrier frequency time slot are one or more first activated carrier frequency time slots after the multi-carrier module is activated, and a time length of the one or more first activated carrier frequency time slots correspond to the time length required for carrier frequency time slots from a dormant state to an available state.

When the time slot quantity of the carrier frequency time slots having traffic occupancy is not zero, the first carrier frequency time slot is one idle carrier frequency time slot in an active state located before a time slot segment of the carrier frequency time slots having traffic occupancy in case that the time length required for carrier frequency time slots from a dormant state to an available state is the time length of one carrier frequency time slot. For another example, if the time length required for carrier frequency time slots from a dormant state to an available state is the time length of 2 or 1.5 carrier frequency time slots, the first carrier frequency time slot are two idle carrier frequency time slots in an active state located before the time slot segment of the carrier frequency time slots having traffic occupancy. That is to say, the first carrier frequency time slot are one or more idle carrier frequency time slots in an active state located before the time slot segment of the carrier frequency time slots having traffic occupancy, a time length of the one or more idle carrier frequency time slots correspond to the time length required for carrier frequency time slots from a dormant state to an available state.

The carrier frequency time slot having traffic occupancy in the embodiment of the present invention means that one or more carrier time slots on the carrier frequency time slot have traffic occupancy. If none of the carrier time slots on a carrier frequency time slot have traffic occupancy, the carrier frequency time slot may be referred to as an idle carrier frequency time slot. The carrier frequency time slots having traffic occupancy in this embodiment may be one or more carrier frequency time slots. When the carrier frequency time slots having traffic occupancy are multiple carrier frequency time slots, the carrier frequency time slots having traffic occupancy may be carrier frequency time slots having continuous time slot numbers or carrier frequency time slots having discontinuous time slot numbers. The time slot segment of the carrier frequency time slots having traffic occupancy may represent a time slot segment having continuous time slot numbers of carrier frequency time slots or a time slot segment having discontinuous time slot numbers of carrier frequency time slots. When the time slot segment of the carrier frequency time slots having traffic occupancy represents a time slot segment having discontinuous time slot numbers of carrier frequency time slots, the first carrier frequency time slot and the last carrier frequency time slot in the time slot segment are carrier frequency time slots having traffic occupancy, and the time slot segment may contain one or more idle carrier frequency time slots.

In 8200, the base station controls the carrier frequency time slots and carrier time slots of the multi-carrier module according to the first carrier frequency time slot.

In the embodiment of the present invention, the base station may or may not control carrier frequency time slots and carrier time slots in order of carrier frequency time slot numbers. For ease of description, illustrations are made through an example that the base station controls carrier frequency time slots and carrier time slots in order of carrier frequency time slot numbers uniformly in the embodiments of the present invention. However, persons of ordinary skill in the art can understand that, the illustrations made through the example that the base station controls carrier frequency time slots and carrier time slots in order of carrier frequency time slot numbers do not represent that the base station can only control carrier frequency time slots and carrier time slots in order of carrier frequency time slot numbers in the present invention, and the protection scope of the present invention shall fall within the appended claims.

The time slot quantity of the carrier frequency time slots having traffic occupancy is not zero.

If a time slot quantity of carrier time slots required by new traffic is greater than a time slot quantity of idle carrier time slots in the active state, the base station activates carrier frequency time slots in the dormant state in the multi-carrier module, and then assigns the new traffic to other idle time slots in the active state than the first carrier frequency time slot. The base station may activate all carrier frequency time slots in the dormant state in the multi-carrier module. Optionally, the base station may also activate only a part of carrier frequency time slots meeting the requirements of the new traffic from the carrier frequency time slots in the dormant state. Optionally, when activating carrier frequency time slots in the dormant state, the base station may activate the dormant carrier frequency time slot in order of carrier frequency time slot numbers. Optionally, when assigning the new traffic to the other idle carrier time slots in the active state than the first carrier frequency time slot, that is, carrier time slots on the first carrier frequency time slot, the base station may assign the new traffic to the other idle carrier time slots in the active state than the carrier time slots on the first carrier frequency time slot in order of carrier frequency time slot numbers. When all carrier frequency time slots other than the first carrier frequency time slot in the multi-carrier module are occupied by traffic, the new traffic is assigned to the first carrier frequency time slot. It should be noted that, when the multi-carrier module is in the dormant state, the base station needs to first awaken the multi-carrier module before activating the carrier frequency time slots in the dormant state.

If the time slot quantity of the carrier time slots required by the new traffic is smaller than the time slot quantity of the idle carrier time slots in the active state or no new traffic requirements exist, the base station determines candidate dormant carrier frequency time slots, and controls the carrier frequency time slots and the carrier time slots of the multi-carrier module according to the candidate dormant carrier frequency time slots. The candidate dormant time slots are other idle carrier frequency time slots in the active state than the first carrier frequency time slot. In addition, when a time slot quantity of the candidate dormant carrier frequency time slots is greater than or equal to 1 and smaller than or equal to 6, the base station controls the candidate dormant carrier frequency time slots to enter the dormant state. In addition, before the base station brings the candidate dormant carrier frequency time slots into dormancy, if a base station controller knows that a time slot quantity of carrier time slots in an idle state in the multi-carrier module of the base station is greater than a carrier quantity configured in the multi-carrier module, the base station controller sends a message carrying control information to the base station. The control information indicates that the base station concentrates the traffic occupancy on carrier frequency time slots having continuous time slot numbers in the multi-carrier module. The base station switches traffic on carrier time slots having traffic occupancy to other carrier time slots in the idle state than the carrier time slots corresponding to the first carrier frequency time slot according to the received message carrying the control information, so as to concentrate the traffic occupancy on several continuous carrier frequency time slots in the carrier frequency and thus increase the time slot quantity of the candidate dormant carrier frequency time slots. The message carrying the control information may be a switching command message, a carrier number message, a channel number message, or a frequency point number message, that is, the control information is carried in the switching command message, the carrier number message, the channel number message, or the frequency point number message.

The time slot quantity of the carrier frequency time slots having traffic occupancy is zero.

All carrier frequency time slots of the multi-carrier module enter the dormant state, and the base station brings the multi-carrier module into dormancy. Therefore, when new traffic requirements exist, the base station needs to awaken the dormant multi-carrier module, and then activates the carrier frequency time slots in the multi-carrier module, in which the first carrier frequency time slot is the first activated carrier frequency time slot in the multi-carrier module. Since a multi-carrier broadband power amplifier gate voltage of the base station cannot vary rapidly from high to low with a control signal in time during the turn-on and turn-off of the carrier frequency time slots, the first carrier frequency time slot of the base station activated after the multi-carrier module is turned off may not bear traffic, that is, none of the carrier time slots on the first carrier frequency time slot are assigned with traffic, and the traffic is assigned from the second activated carrier frequency time slot. Optionally, the base station may assign traffic from the second activated carrier frequency time slot in order of time slot numbers.

Through the method in this embodiment, the method of not turning off an idle carrier frequency time slot in the active state located before a time slot segment of carrier frequency time slots having traffic occupancy and the method of not assigning traffic to the first activated carrier frequency time slot but assigning traffic from the second activated carrier frequency time slot after activating the dormant multi-carrier module are employed in the control of time slot occupancy by the base station, so as to dynamically activate carrier frequency time slots in the dormant state for traffic assignment and turn off a part of idle carrier frequency time slots in the active state, thereby solving the problem of deterioration of an RF index of the multi-carrier module caused by dynamically turning off the idle carrier frequency time slots in the active state of the multi-carrier module by the base station. In addition, a part of carrier frequency time slots of the multi-carrier module enter the dormant state by turning off the turn-off idle carrier frequency time slots in the active state, so that the quantity of time slots in the active state of the multi-carrier module is reduced, thereby lowering power consumption of the multi-carrier module, and realizing energy saving of the multi-carrier module.

As shown in FIG. 8, a base station 9000 is provided in an embodiment of the present invention, which includes: a time length determination unit 9002, a time slot occupancy information determination unit 9004, and a time slot control unit 9006.

The time length determination unit 9002 is configured to determine a time length required for carrier frequency time slots of a multi-carrier module of the base station 9000 from a dormant state to an available state. The time slot occupancy information determination unit 9004 is configured to determine time slot occupancy information of the multi-carrier module of the base station 9000. The time slot control unit 9006 is configured to control the carrier frequency time slots and carrier time slots of the multi-carrier module according to the time length determined by the time length determination unit 9002 and the time slot occupancy information of the multi-carrier module determined by the time slot occupancy information determination unit 9004. The carrier frequency time slots of the multi-carrier module are time slot columns having the same time slot number on all carriers in the multi-carrier module. The carrier time slots of the multi-carrier module are time slots corresponding to different carriers in the carrier frequency time slots of the multi-carrier module. The dormant state is a time slot state of the carrier frequency time slots of the multi-carrier module when a carrier frequency turn-off circuit of the multi-carrier module is turned off. The available state is a time slot state of the carrier frequency time slots of the multi-carrier module when a carrier frequency output RF index of the multi-carrier module is normal.

In addition, the base station 9000 further includes a first carrier frequency time slot determination unit 9008.

The first carrier frequency time slot determination unit 9008 is configured to determine a first carrier frequency time slot according to the time length determined by the time length determination unit 9002 and the time slot occupancy information determined by the time slot occupancy information determination unit 9004. The time slot control unit 9006 is further configured to control the carrier frequency time slots and the carrier time slots of the multi-carrier module of the base station 9000 according to the first carrier frequency time slot determined by the first carrier frequency time slot determination unit 9008. When a time slot quantity of carrier frequency time slots having traffic occupancy in the time slot occupancy information that is determined by the time slot occupancy information determination unit 9004 is zero, the first carrier frequency time slot are one or more first activated carrier frequency time slots after the multi-carrier module of the base station 9000 is activated, and a time length of the one or more first activated carrier frequency time slots correspond to the time length required for carrier frequency time slots from a dormant state to an available state. When the time slot quantity of the carrier frequency time slots having traffic occupancy in the time slot occupancy information that is determined by the time slot occupancy information determination unit 9004 is not zero, the first carrier frequency time slot are one or more idle carrier frequency time slots in an active state located before a time slot segment of the carrier frequency time slots having traffic occupancy , and a time length of the one or more idle carrier frequency time slots correspond to the time length required for carrier frequency time slots from a dormant state to an available state.

In addition, the base station 9000 further includes a determination unit 9010 of the carrier time slot quantity required by new traffic.

The determination unit 9010 of the carrier time slot quantity required by the new traffic is configured to determine a time slot quantity of carrier time slots required by new traffic.

When the time slot quantity of the carrier frequency time slots having traffic occupancy in the time slot occupancy information that is determined by the time slot occupancy information determination unit 9004 is not zero, if the carrier time slot quantity required by the new traffic that is determined by the determination unit 9010 of the carrier time slot quantity required by the new traffic is greater than a time slot quantity of carrier time slots in an idle state in the time slot occupancy information that is determined by the time slot occupancy information determination unit 9004, the time slot control unit 9006 is further configured to activate carrier frequency time slots in the dormant state in the multi-carrier module of the base station 9000. The time slot control unit 9006 is further configured to assign the new traffic to other carrier time slots in the idle state than carrier time slots on the first carrier frequency time slot that is determined by the first carrier frequency time slot determination unit 9008.

In addition, the base station 9000 further includes a candidate dormant carrier frequency time slot determination unit 9012.

The candidate dormant carrier frequency time slot determination unit 9012 is configured to determine candidate dormant carrier frequency time slots when the time slot quantity of the carrier frequency time slots having traffic occupancy in the time slot occupancy information that is determined by the time slot occupancy information determination unit 9004 is not zero. The candidate dormant carrier frequency time slots are other idle carrier frequency time slots in the active state than the first carrier frequency time slot that is determined by the first carrier frequency time slot determination unit 9008. The time slot control unit 9006 is further configured to control the carrier frequency time slots and the carrier time slots of the multi-carrier module of the base station 9000 according to the candidate dormant carrier frequency time slots determined by the candidate dormant carrier frequency time slot determination unit 9012. The idle carrier frequency time slots are the carrier frequency time slots when all carrier time slots on time slot numbers corresponding to the carrier frequency time slots in the multi-carrier module are in the idle state.

In addition, when a time slot quantity of the candidate dormant carrier frequency time slots is greater than or equal to 1 and smaller than or equal to 6, the time slot control unit 9006 is further configured to control the candidate dormant carrier frequency time slots to enter the dormant state.

In addition, the base station 9000 further includes a carrier quantity determination unit 9014 and a receiving unit 9018.

The carrier quantity determination unit 9014 is configured to determine a carrier quantity configured in the multi-carrier module of the base station 9000.

The receiving unit 9018 is configured to receive a message carrying control information. The control information indicates that the base station 9000 concentrates the traffic occupancy on carrier frequency time slots having continuous time slot numbers in the multi-carrier module.

The time slot control unit 9006 is further configured to switch traffic on carrier time slots having traffic occupancy to other carrier time slots in the idle state than carrier time slots corresponding to the first carrier frequency time slot that is determined by the first carrier frequency time slot determination unit 9008 according to the message carrying the control information received by the receiving unit 9018 when a time slot quantity of carrier time slots in the idle state in the time slot occupancy information that is determined by the time slot occupancy information determination unit 9004 is greater than the carrier quantity determined by the carrier quantity determination unit 9014, so as to concentrate the traffic occupancy on several continuous carrier frequency time slots in the carrier frequency and thus increase the time slot quantity of the candidate dormant carrier frequency time slots. The message carrying the control information may be a switching command message, a carrier number message, a channel number message, or a frequency point number message, that is, the control information is carried in the switching command message, the carrier number message, the channel number message, or the frequency point number message.

In addition, when the time slot quantity of the carrier frequency time slots having traffic occupancy in the time slot occupancy information that is determined by the time slot occupancy information determination unit 9004 is zero, if the multi-carrier module of the base station 9000 is in the dormant state, the time slot control unit 9006 is further configured to awaken the multi-carrier module of the base station 9000. The time slot control unit 9006 is further configured to activate the carrier frequency time slots of the multi-carrier module of the base station 9000. The time slot control unit 9006 is further configured to assign new traffic to carrier frequency time slots in the active state after the first carrier frequency time slot that is determined by the first carrier frequency time slot determination unit 9008.

In addition, the time slot control unit 9006 is further configured to control the carrier frequency time slots and the carrier time slots of the multi-carrier module of the base station 9000 in order of time slot numbers of the carrier frequency time slots according to the time length determined by the time length determination unit 9002 and the time slot occupancy information determined by the time slot occupancy information determination unit 9004.

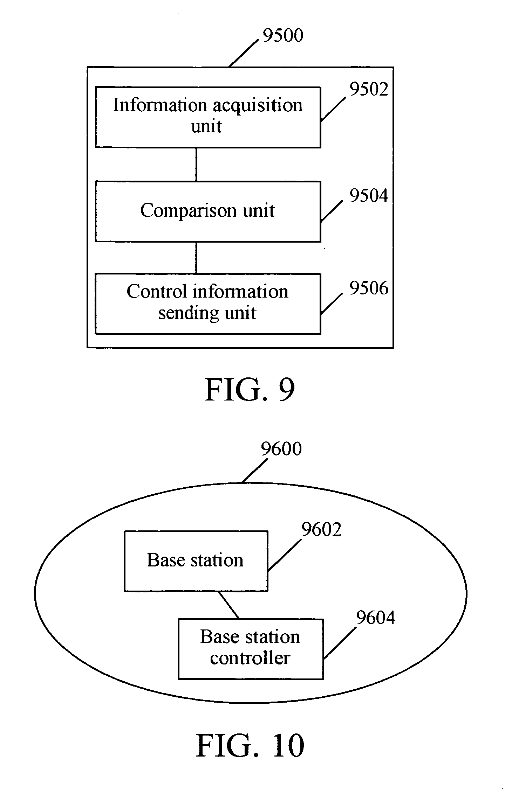

As shown in FIG. 9, a base station controller 9500 is provided in an embodiment of the present invention, which includes an information acquisition unit 9502, a comparison unit 9504, and a control information sending unit 9506.

The information acquisition unit 9502 is configured to acquire a time slot quantity of carrier time slots in an idle state in a multi-carrier module of a base station and a carrier quantity configured in the multi-carrier module. The comparison unit 9502 is configured to compare the time slot quantity and the carrier quantity acquired by the information acquisition unit 9502. The control information sending unit 9506 is configured to send a message carrying control information to the base station when the comparison unit 9502 obtains by comparison that the time slot quantity is greater than the carrier quantity. The control information indicates that the base station concentrates traffic occupancy on carrier frequency time slots having continuous time slot numbers in the multi-carrier module. The carrier frequency time slots are time slot columns having the same time slot number on all carriers in the multi-carrier module. The carrier time slots are time slots corresponding to different carriers in the carrier frequency time slots of the multi-carrier module.

As shown in FIG. 10, another communication system 9600 is provided in an embodiment of the present invention, which includes a base station 9602. The base station 9602 may accomplish all functions of the base station in the embodiment of the above method for controlling time slots in the present invention.

In addition, the communication system 9600 further includes a base station controller 9604. The base station controller 9604 acquires a time slot quantity of carrier time slots in an idle state in a multi-carrier module of the base station 9602 and a carrier quantity configured in the multi-carrier module; and sends a message carrying control information to the base station 9602 when the time slot quantity is greater than the carrier quantity. The control information indicates that the base station 9602 concentrates traffic occupancy on carrier frequency time slots having continuous time slot numbers in the multi-carrier module.

Through the descriptions of the preceding embodiments, those skilled in the art may understand that the present invention may be implemented by software and a necessary universal hardware platform. Based on such understandings, all or part of the technical solution under the present invention that makes contributions to the prior art may be essentially embodied in the form of a software product. The software product may be stored in a storage medium, which can be a Read-Only Memory (ROM), a Random Access Memory (RAM), a magnetic disk, or a Compact Disk Read-Only Memory (CD-ROM). The software product includes a number of instructions that enable a computer device (personal computer, server, or network device) to execute the methods provided in the embodiments of the present invention.

The above are merely preferred embodiments of the present invention, but not intended to limit the scope of the present invention. Any modification, equivalent replacement, or improvement made without departing from the present invention should fall within the scope of the present invention.

## Claims

1. A method for adjusting a power amplifier voltage, comprising:
determining (2100), by a base station, a power amplifier voltage in a statistical time period according to a relation between a power amplifier output power and a power amplifier efficiency, and carrier power control information;
selecting (2200) a power amplifier voltage in a previous statistical time period of a statistical time period of a current time point as a target power amplifier voltage; and
adjusting (2300) a power amplifier voltage at the current time point according to the target power amplifier voltage,
wherein a power amplifier of a multi-carrier module works in a linear amplification area in the statistical time period.

2. The method according to claim 1, wherein the determining the power amplifier voltage in the statistical time period according to the relation between the power amplifier output power, and the power amplifier efficiency and the carrier power control information comprises:
determining an output power of each working time slot in the statistical time period according to the carrier power control information;
determining an average output power of the power amplifier in the statistical time period according to the output power of each working time slot in the statistical time period; and
determining a power amplifier voltage corresponding to the average output power according to the relation between the power amplifier output power and the power amplifier efficiency.

3. The method according to claim 1 or 2, wherein the determining the power amplifier voltage in the statistical time period according to the relation between the power amplifier output power and the power amplifier efficiency and the carrier power control information comprises:
determining a first power amplifier voltage in a first statistical time period and a second power amplifier voltage in a second statistical time period according to the carrier power control information and the relation between the power amplifier output power and the power amplifier efficiency,
wherein the first statistical time period is smaller than the second statistical time period.

4. The method according to claim 3, wherein the selecting the power amplifier voltage in the previous statistical time period of the statistical time period of the current time point as the target power amplifier voltage comprises:
selecting a power amplifier voltage in the previous first statistical time period of the first statistical time period of the current time point as a first target power amplifier voltage; or
selecting a power amplifier voltage in the previous second statistical time period of the second statistical time period of the current time point as a second target power amplifier voltage.

5. The method according to claim 4, wherein the adjusting the power amplifier voltage at the current time point according to the target power amplifier voltage comprises:
raising the power amplifier voltage at the current time point to the first target power amplifier voltage when the power amplifier voltage at the current time point is smaller than the first target power amplifier voltage; or
lowering the power amplifier voltage at the current time point to the second target power amplifier voltage when the power amplifier voltage at the current time point is greater than the second target power amplifier voltage.

6. A base station, comprising:
a statistical time period determination unit (4100), configured to determine a statistical time period of a power amplifier voltage;
a power amplifier voltage determination unit (4200), configured to determine a power amplifier voltage in the statistical time period determined by the statistical time period determination unit according to a relation between a power amplifier output power and a power amplifier efficiency, and carrier power control information;
a target power amplifier voltage selection unit (4300), configured to select a power amplifier voltage determined by the power amplifier voltage determination unit in a previous statistical time period of a statistical time period of a current time point as a target power amplifier voltage; and
a power amplifier voltage adjustment unit (4400), configured to adjust a power amplifier voltage at the current time point according to the target power amplifier voltage determined by the target power amplifier voltage selection unit.

7. The base station according to claim 6, wherein the power amplifier voltage determination unit comprises:
an output power determination unit, configured to determine an average output power in the statistical time period according to the carrier power control information.

8. The base station according to one of claims 6 or 7, wherein
the statistical time period determination unit is further configured to determine a first statistical time period and a second statistical time period, wherein the first statistical time period is smaller than the second statistical time period;
the power amplifier voltage determination unit is further configured to determine a first power amplifier voltage in the first statistical time period and a second power amplifier voltage in the second statistical time period that are determined by the statistical time period determination unit according to the relation between the power amplifier output power and the power amplifier efficiency and the carrier power control information;
the target power amplifier voltage selection unit is further configured to select the first power amplifier voltage determined by the power amplifier voltage determination unit in the previous first statistical time period of the first statistical time period of the current time point as a first target power amplifier voltage, and select the second power amplifier voltage determined by the power amplifier voltage determination unit in the previous second statistical time period of the second statistical time period of the current time point as a second target power amplifier voltage; and
the power amplifier voltage adjustment unit is further configured to raise the power amplifier voltage at the current time point to the first target power amplifier voltage when the power amplifier voltage at the current time point is smaller than the first target power amplifier voltage; and lower the power amplifier voltage at the current time point to the second target power amplifier voltage when the power amplifier voltage at the current time point is greater than the second target power amplifier voltage.

## Patentansprüche

1. Verfahren zum Einstellen einer Leistungsverstärkerspannung, das Folgendes umfasst:
Bestimmen (2100) einer Leistungsverstärkerspannung in einer statistischen Zeitdauer in Übereinstimmung mit einer Beziehung zwischen einer Leistungsverstärker-Ausgangsleistung und einem Leistungsverstärkerwirkungsgrad und Trägerleistungs-Steuerinformationen durch eine Basisstation;
Auswählen (2200) einer Leistungsverstärkerspannung in einer einer statistischen Zeitdauer eines aktuellen Zeitpunkts vorhergehenden statistischen Zeitdauer als eine Soll-Leistungsverstärkerspannung; und
Einstellen (2300) einer Leistungsverstärkerspannung zum aktuellen Zeitpunkt in Übereinstimmung mit der Soll-Leistungsverstärkerspannung,
wobei ein Leistungsverstärker eines Mehrträgermoduls in der statistischen Zeitdauer in einem linearen Verstärkungsbereich arbeitet.

2. Verfahren nach Anspruch 1, wobei das Bestimmen der Leistungsverstärkerspannung in der statistischen Zeitdauer in Übereinstimmung mit der Beziehung zwischen der Leistungsverstärker-Ausgangsleistung und dem Leistungsverstärkerwirkungsgrad und den Trägerleistungs-Steuerinformationen Folgendes umfasst:
Bestimmen einer Ausgangsleistung jedes Arbeitszeitschlitzes in der statistischen Zeitdauer in Übereinstimmung mit den Trägerleistungs-Steuerinformationen;
Bestimmen einer durchschnittlichen Ausgangsleistung des Leistungsverstärkers in der statistischen Zeitdauer in Übereinstimmung mit der Ausgangsleistung jedes Arbeitszeitschlitzes in der statistischen Zeitdauer; und
Bestimmen einer Leistungsverstärkerspannung, die der durchschnittlichen Ausgangsleistung entspricht, in Übereinstimmung mit der Beziehung zwischen der Leistungsverstärker-Ausgangsleistung und dem Leistungsverstärkerwirkungsgrad.

3. Verfahren nach Anspruch 1 oder 2, wobei das Bestimmen der Leistungsverstärkerspannung in der statistischen Zeitdauer in Übereinstimmung mit der Beziehung zwischen der Leistungsverstärker-Ausgangsleistung und dem Leistungsverstärkerwirkungsgrad und den Trägerleistungs-Steuerinformationen Folgendes umfasst:
Bestimmen einer ersten Leistungsverstärkerspannung in einer ersten statistischen Zeitdauer und einer zweiten Leistungsverstärkerspannung in einer zweiten statistischen Zeitdauer in Übereinstimmung mit den Trägerleistungs-Steuerinformationen und der Beziehung zwischen der Leistungsverstärker-Ausgangsleistung und dem Leistungsverstärkerwirkungsgrad,
wobei die erste statistische Zeitdauer kleiner als die zweite statistische Zeitdauer ist.

4. Verfahren nach Anspruch 3, wobei das Auswählen der Leistungsverstärkerspannung in der der statistischen Zeitdauer des aktuellen Zeitpunkts vorhergehenden statistischen Zeitdauer als die Soll-Leistungsverstärkerspannung Folgendes umfasst:
Auswählen einer Leistungsverstärkerspannung in der der ersten statistischen Zeitdauer des aktuellen Zeitpunkts vorhergehenden ersten statistischen Zeitdauer als eine erste Soll-Leistungsverstärkerspannung; oder
Auswählen einer Leistungsverstärkerspannung in der der zweiten statistischen Zeitdauer des aktuellen Zeitpunkts vorhergehenden zweiten statistischen Zeitdauer als eine zweite Soll-Leistungsverstärkerspannung.

5. Verfahren nach Anspruch 4, wobei das Einstellen der Leistungsverstärkerspannung zum aktuellen Zeitpunkt in Übereinstimmung mit der Soll-Leistungsverstärkerspannung Folgendes umfasst:
Erhöhen der Leistungsverstärkerspannung zum aktuellen Zeitpunkt auf die erste Soll-Leistungsverstärkerspannung, wenn die Leistungsverstärkerspannung zum aktuellen Zeitpunkt kleiner als die erste Soll-Leistungsverstärkerspannung ist; oder
Verringern der Leistungsverstärkerspannung zum aktuellen Zeitpunkt auf die zweite Soll-Leistungsverstärkerspannung, wenn die Leistungsverstärkerspannung zum aktuellen Zeitpunkt größer als die zweite Soll-Leistungsverstärkerspannung ist.

6. Basisstation, die Folgendes umfasst:
eine Bestimmungseinheit (4100) für statistische Zeitdauern, die konfiguriert ist, eine statistische Zeitdauer einer Leistungsverstärkerspannung zu bestimmen;
eine Leistungsverstärkerspannungs-Bestimmungseinheit (4200), die konfiguriert ist, eine Leistungsverstärkerspannung in der durch die Bestimmungseinheit für statistische Zeitdauern bestimmten statistischen Zeitdauer in Übereinstimmung mit einer Beziehung zwischen einer Leistungsverstärker-Ausgangsleistung und einem Leistungsverstärkerwirkungsgrad und Trägerleistungs-Steuerinformationen zu bestimmen;
eine Soll-Leistungsverstärkerspannungs-Auswahleinheit (4300), die konfiguriert ist, eine durch die Leistungsverstärkerspannungs-Bestimmungseinheit in einer einer statistischen Zeitdauer eines aktuellen Zeitpunkts vorhergehenden statistischen Zeitdauer bestimmte Leistungsverstärkerspannung als eine Soll-Leistungsverstärkerspannung auszuwählen; und
eine Leistungsverstärkerspannungs-Einstelleinheit (4400), die konfiguriert ist, eine Leistungsverstärkerspannung zu dem aktuellen Zeitpunkt in Übereinstimmung mit der durch die Soll-Leistungsverstärkerspannungs-Auswahleinheit bestimmten Soll-Leistungsverstärkerspannung einzustellen.

7. Basisstation nach Anspruch 6, wobei die Leistungsverstärkerspannungs-Bestimmungseinheit Folgendes umfasst:
eine Ausgangsleistungs-Bestimmungseinheit, die konfiguriert ist, eine durchschnittliche Ausgangsleistung in der statistischen Zeitdauer in Übereinstimmung mit den Trägerleistungs-Steuerinformationen zu bestimmen.

8. Basisstation nach einem der Ansprüche 6 oder 7, wobei
die Bestimmungseinheit für statistische Zeitdauern ferner konfiguriert ist, eine erste statistische Zeitdauer und eine zweite statistische Zeitdauer zu bestimmen, wobei die erste statistische Zeitdauer kleiner als die zweite statistische Zeitdauer ist;
die Leistungsverstärkerspannungs-Bestimmungseinheit ferner konfiguriert ist, eine erste Leistungsverstärkerspannung in der ersten statistischen Zeitdauer und eine zweite Leistungsverstärkerspannung in der zweiten statistischen Zeitdauer, die durch die Bestimmungseinheit für statistische Zeitdauern bestimmt werden, in Übereinstimmung mit der Beziehung zwischen der Leistungsverstärker-Ausgangsleistung und dem Leistungsverstärkerwirkungsgrad und den Trägerleistungs-Steuerinformationen zu bestimmen;
die Soll-Leistungsverstärkerspannungs-Auswahleinheit ferner konfiguriert ist, die durch die Leistungsverstärkerspannungs-Bestimmungseinheit in der der ersten statistischen Zeitdauer des aktuellen Zeitpunkts vorhergehenden ersten statistischen Zeitdauer bestimmte erste Leistungsverstärkerspannung als eine erste Soll-Leistungsverstärkerspannung auszuwählen und die durch die Leistungsverstärkerspannungs-Bestimmungseinheit in der der zweiten statistischen Zeitdauer des aktuellen Zeitpunkts vorhergehenden zweiten statistischen Zeitdauer bestimmte zweite Leistungsverstärkerspannung als eine zweite Soll-Leistungsverstärkerspannung auszuwählen; und
die Leistungsverstärkerspannungs-Einstelleinheit ferner konfiguriert ist, die Leistungsverstärkerspannung zum aktuellen Zeitpunkt auf die erste Soll-Leistungsverstärkerspannung zu erhöhen, wenn die Leistungsverstärkerspannung zum aktuellen Zeitpunkt kleiner als die erste Soll-Leistungsverstärkerspannung ist; und die Leistungsverstärkerspannung zum aktuellen Zeitpunkt auf die zweite Soll-Leistungsverstärkerspannung zu verringern, wenn die Leistungsverstärkerspannung zum aktuellen Zeitpunkt größer als die zweite Soll-Leistungsverstärkerspannung ist.

## Revendications

1. Procédé permettant d'ajuster la tension d'un amplificateur de puissance, comprenant :
la détermination (2100) d'une tension d'amplificateur de puissance par une station de base dans un intervalle de temps statistique en fonction d'une relation établie entre la puissance de sortie de l'amplificateur de puissance et le rendement de l'amplificateur de puissance et d'informations sur la commande de puissance de porteuse,
la sélection (2200) d'une tension de l'amplificateur de puissance lors d'un intervalle de temps statistique précédant un intervalle de temps statistique du point actuel dans le temps comme tension cible de l'amplificateur de puissance, et
l'ajustement (2300) d'une tension de l'amplificateur de puissance lors du point actuel dans le temps en fonction de la tension cible de l'amplificateur de puissance,
dans lequel l'amplificateur de puissance d'un module à porteuses multiples fonctionne dans une zone linéaire d'amplification dans l'intervalle de temps statistique.

2. Procédé selon la revendication 1, dans lequel la détermination de la tension de l'amplificateur de puissance dans l'intervalle de temps statistique en fonction de la relation établie entre la puissance de sortie de l'amplificateur de puissance et le rendement de l'amplificateur de puissance et des informations sur la commande de puissance de porteuse comprend :
la détermination d'une puissance de sortie de chaque tranche de temps de fonctionnement dans l'intervalle de temps statistique en fonction des informations sur la commande de puissance de porteuse,
la détermination d'une puissance moyenne de sortie de l'amplificateur de puissance dans l'intervalle de temps statistique en fonction de la puissance de sortie de chaque tranche de temps de fonctionnement dans l'intervalle de temps statistique, et
la détermination d'une tension de l'amplificateur de puissance correspondant à la puissance moyenne de sortie en fonction de la relation établie entre la puissance de sortie de l'amplificateur de puissance et le rendement de l'amplificateur de puissance.

3. Procédé selon la revendication 1 ou 2, dans lequel la détermination de la tension de l'amplificateur de puissance dans l'intervalle de temps statistique en fonction de la relation établie entre la puissance de sortie de l'amplificateur de puissance et le rendement de l'amplificateur de puissance et des informations sur la commande de puissance de porteuse comprend :
la détermination d'une première tension de l'amplificateur de puissance dans un premier intervalle de temps statistique et d'une seconde tension de l'amplificateur de puissance dans un second intervalle de temps statistique en fonction des informations sur la commande de puissance de porteuse et de la relation établie entre la puissance de sortie de l'amplificateur de puissance et le rendement de l'amplificateur de puissance,
dans lequel le premier intervalle de temps statistique est plus court que le second intervalle de temps statistique.

4. Procédé selon la revendication 3, dans lequel la sélection de la tension de l'amplificateur de puissance dans l'intervalle de temps statistique précédant l'intervalle de temps statistique du point actuel dans le temps comme tension cible de l'amplificateur de puissance comprend :
la sélection comme première tension cible de l'amplificateur de puissance d'une tension d'amplificateur de puissance dans le premier intervalle de temps statistique précédant le premier intervalle de temps statistique du point actuel dans le temps, ou
la sélection comme seconde tension cible de l'amplificateur de puissance d'une tension d'amplificateur de puissance dans le second intervalle de temps statistique précédant le second intervalle de temps statistique du point actuel dans le temps.

5. Procédé selon la revendication 4, dans lequel l'ajustement de la tension de l'amplificateur de puissance lors du point actuel dans le temps en fonction de la tension cible de l'amplificateur de puissance comprend :
l'élévation la tension de l'amplificateur de puissance lors du point actuel dans le temps jusqu'à la première tension cible de l'amplificateur de puissance lorsque la tension de l'amplificateur de puissance lors du point actuel dans le temps est inférieure à la première tension cible de l'amplificateur de puissance, ou
la diminution de la tension de l'amplificateur de puissance lors du point actuel dans le temps jusqu'à la seconde tension cible de l'amplificateur de puissance lorsque la tension de l'amplificateur de puissance lors du point actuel dans le temps est supérieure à la seconde tension cible de l'amplificateur de puissance.

6. Station de base, comprenant :
une unité de détermination d'intervalle de temps statistique (4100) configurée pour déterminer un intervalle de temps statistique d'une tension d'amplificateur de puissance,
une unité de détermination de tension de l'amplificateur de puissance (4200) configurée pour déterminer une tension de l'amplificateur de puissance dans l'intervalle de temps statistique déterminé par l'unité de détermination d'intervalle de temps statistique en fonction d'une relation établie entre la puissance de sortie de l'amplificateur de puissance et le rendement de l'amplificateur de puissance et d'informations sur la commande de puissance de porteuse,
une unité de sélection de tension cible de l'amplificateur de puissance (4300) configurée pour sélectionner la tension de l'amplificateur de puissance déterminée par l'unité de détermination de tension de l'amplificateur de puissance dans un intervalle de temps statistique précédant l'intervalle de temps statistique d'un point actuel dans le temps comme tension cible de l'amplificateur de puissance, et
une unité d'ajustement de tension de l'amplificateur de puissance (4400) configurée pour ajuster la tension de l'amplificateur de puissance lors du point actuel dans le temps en fonction de la tension cible de l'amplificateur de puissance définie par l'unité de sélection de tension cible de l'amplificateur de puissance.

7. Station de base selon la revendication 6, dans laquelle l'unité de détermination de la tension de l'amplificateur de puissance comprend :
une unité de détermination de puissance de sortie configurée pour déterminer une puissance moyenne de sortie dans l'intervalle de temps statistique en fonction des informations sur la commande de puissance de porteuse.

8. Station de base selon l'une des revendications 6 ou 7, dans laquelle
l'unité de détermination d'intervalle de temps statistique est en outre configurée pour déterminer un premier intervalle de temps statistique et un second intervalle de temps statistique, le premier intervalle de temps statistique étant plus court que le second intervalle de temps statistique,
l'unité de détermination de tension de l'amplificateur de puissance est en outre configurée pour déterminer une première tension de l'amplificateur de puissance dans le premier intervalle de temps statistique et une seconde tension de l'amplificateur de puissance dans le second intervalle de temps statistique qui sont déterminés par l'unité de détermination d'intervalle de temps statistique en fonction de la relation établie entre la puissance de sortie de l'amplificateur de puissance et le rendement de l'amplificateur de puissance et des informations sur la commande de puissance de porteuse,
l'unité de sélection de tension cible de l'amplificateur de puissance est en outre configurée pour sélectionner la première tension de l'amplificateur de puissance déterminée par l'unité de détermination de tension de l'amplificateur de puissance dans le premier intervalle de temps statistique précédant le premier intervalle de temps statistique du point actuel dans le temps comme première tension cible de l'amplificateur de puissance, et pour sélectionner la seconde tension de l'amplificateur de puissance déterminée par l'unité de détermination de tension de l'amplificateur de puissance dans le second intervalle de temps statistique précédant le second intervalle de temps statistique du point actuel dans le temps comme seconde tension cible de l'amplificateur de puissance, et
l'unité d'ajustement de tension de l'amplificateur de puissance est en outre configurée pour élever la tension de l'amplificateur de puissance lors du point actuel dans le temps jusqu'à la première tension cible de l'amplificateur de puissance lorsque la tension de l'amplificateur de puissance lors du point actuel dans le temps est inférieure à la première tension cible de l'amplificateur de puissance, et pour diminuer la tension de l'amplificateur de puissance lors du point actuel dans le temps jusqu'à la seconde tension cible de l'amplificateur de puissance lorsque la tension de l'amplificateur de puissance lors du point actuel dans le temps est supérieure à la seconde tension cible de l'amplificateur de puissance.
